# EUROPEAN PATENT SPECIFICATION

(11) **EP 1 641 074 B1**
(45) Date of publication and mention of the grant of the patent: **14.02.2007**
(21) Application number: 05018908.3
(22) Date of filing: 31.08.2005
(51) Int. Cl.: H01Q 9/04

(54) **Antenna device**
Antennenanordnung
Dispositif d'antenne

(30) Priority: 01.09.2004 JP 2004254260; 06.12.2004 JP 2004352803
(43) Date of publication of application: 29.03.2006
(73) Proprietor: ALPS ELECTRIC CO., LTD., Tokyo 145-8501 (JP)
(72) Inventor: Sasaki, Kazuhiro, Ota-ku, Tokyo 145-9501 (JP); Shikata, Masaru, Ota-ku, Tokyo 145-9501 (JP); Konno, Yasuhiro, Ota-ku, Tokyo 145-9501 (JP)
(74) Representative: Klunker . Schmitt-Nilson . Hirsch

(56) References cited:
- EP-A- 1 394 899
- US-A1- 2003 103 009

## Description

### BACKGROUND OF THE INVENTION

### 1. Field of the Invention

The present invention relates to an antenna device, and more particularly, to an antenna device in which a circuit board having a low noise amplifying circuit, etc. thereon and an antenna element are unitized.

### 2. Description of the Related Art

Recently, this type of an antenna device has been rapidly and increasingly demanded, for example, as an antenna for an ETC (electronic toll collection system) mounted on a moving object, such as a vehicle, or an antenna for a GPS (global positioning system), etc.

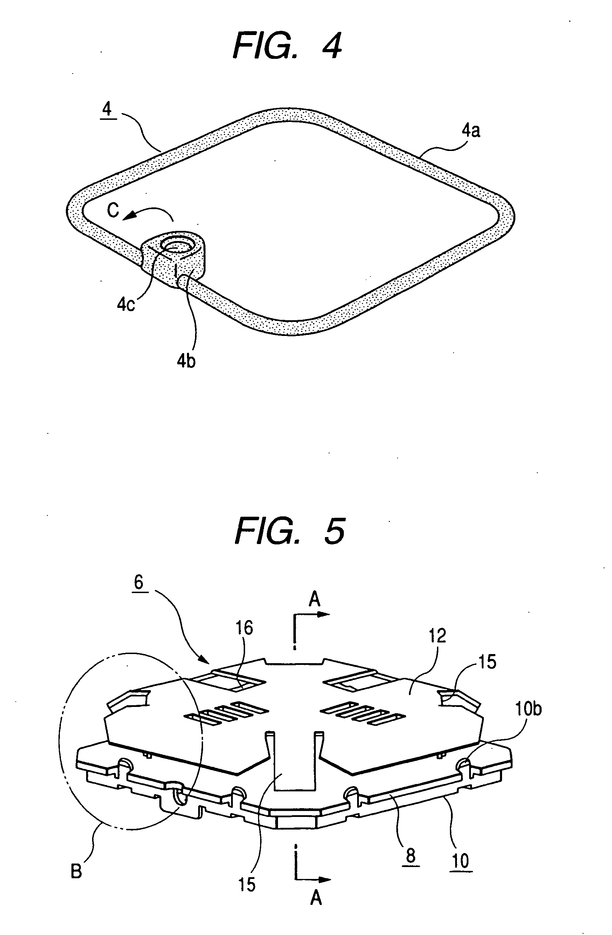

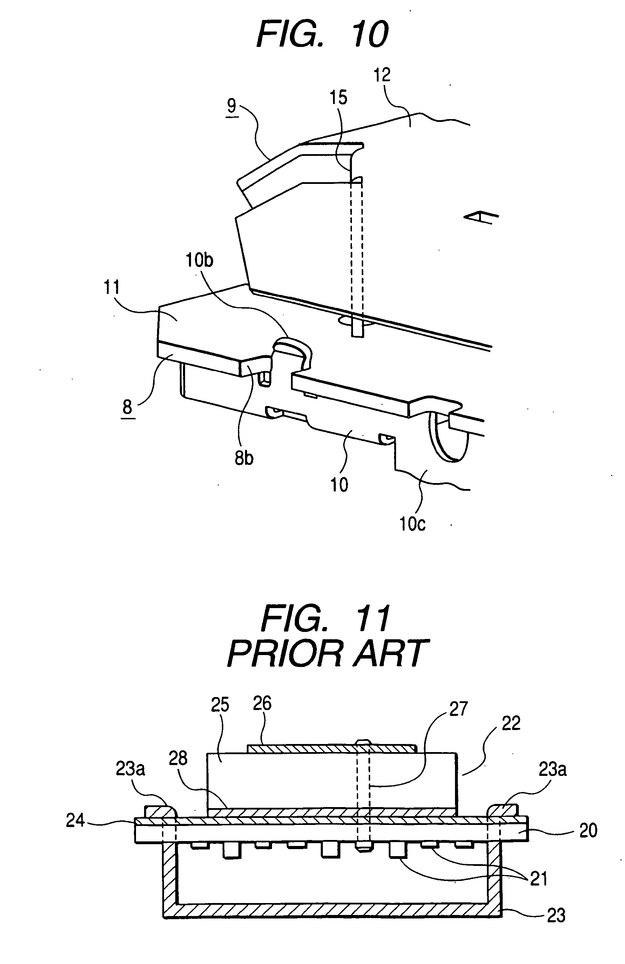

Fig. 11 is a cross-sectional view illustrating a conventional antenna device (for example, see Japanese Unexamined Patent Application Publication No. 2004-88444 (claims 2 to 3, Fig. 5)). The antenna device shown in Fig. 11 is manly composed of a circuit board 20 which has various electronic components 21 mounted on the lower surface thereof, a dielectric antenna 22 mounted on the circuit board 20, a shield case 23 made of a metal sheet which is installed on the circuit board 20 in order to shield the electronic components 21, and a case (radome) for receiving parts of the above-mentioned main body. A ground pattern 24 is provided on the approximately entire upper surface of the circuit board 20. In addition, a wiring pattern (not shown) is provided on the lower surface of the circuit board 20, and a low noise amplifying circuit is formed on the lower surface of the circuit board 20 by connecting the electronic components 21 to the wiring pattern.

Since the dielectric antenna 22 is referred to as a patch antenna, a patch electrode 26, which is a radiation conductor, is provided on the dielectric substrate 25, and an upper end of a feeding pin 27, which passes through the dielectric substrate 25, is soldered to a feeding point of the patch electrode 26. Since a lower end of the feeding pin 27 is soldered to the wiring pattern, the patch electrode 26 is electrically connected to the low noise amplifying circuit. The lower surface of the dielectric antenna 22 is fixed to the ground pattern 24 of the circuit board 20 by double-sided adhesive tape. Furthermore, a plurality of locking pieces 23a projects from the outer circumference of the shield case 23. Each of the locking pieces 23a is inserted into each of holes formed through the circuit board 20, and then the tip thereof is bent. After that, the tip thereof is soldered to the ground pattern 24. Although not shown, a signal cable, such as a coaxial cable, is connected to the wiring pattern so that signals are transmitted to an external receiving circuit through the signal cable.

If a predetermined high frequency signal is supplied to the patch electrode 26 through the low noise amplifying circuit, the conventional antenna device having the above-mentioned structure radiates an electric wave, such as a circularly polarized wave or a linearly polarized wave, from the patch electrode 26. In addition, if the signal wave is received by the patch electrode 26, the electrical signal is output to the external receiving circuit via the low noise amplifying circuit and the signal cable. Furthermore, if the electronic components 21 of the low noise amplifying circuit are covered with the shield case 23 like the antenna device, possibility that characteristics of an antenna deteriorates and an interfering wave from the outside adversely affects the low noise amplifying circuit by an undesirable electronic wave radiated from the low noise amplifying circuit is considerably reduced. Therefore, it is easy to ensure high reliability.

However, according to the above-mentioned conventional antenna device, since the relatively expensive dielectric substrate 25 is used in the antenna device having the dielectric antenna 22 mounted on the circuit board 20, it is difficult to reduce the cost of components. Moreover, a process of manufacturing the antenna device requires a process of attaching the dielectric antenna 22 to the circuit board 20 after the locking pieces 23a of the shield case 23 are reflow-soldered to the ground pattern 24 of the circuit board 20, and a process of reflow-soldering the feeding pin 27 to the feeding point of the patch electrode 26. Accordingly, since assembling work is complicated, it is difficult to reduce assembly cost. Therefore, there has been a problem that the antenna device is difficult to be manufactured at a low price.

Consequently, although it can be regarded to use a sheet metal antenna having the patch antenna construction (so-called a sheet metal patch antenna) instead of the dielectric antenna, the sheet metal patch antenna is difficult to be miniaturized by using a wavelength shortening effect. Therefore, there has been another problem that the whole antenna device is increased in size.

### SUMMARY OF THE INVENTION

In order to solve the above problems, it is an object of the invention to provide an antenna device capable of being manufactured at a low price and being miniaturized.

To achieve the object, according to an aspect of the invention, an antenna device includes a circuit board which is provided with a ground pattern on substantially one entire surface thereof and is provided with a wiring pattern and a plurality of solder lands facing the ground pattern on the other surface thereof, electronic components which are mounted on the other surface of the circuit board and are connected to the wiring pattern, a shield case which is made of a metal sheet and is soldered to the ground pattern so as to cover the electronic components; and a radiation conductor plate which is made of a metal sheet and is disposed on the circuit board so as to face the one surface of the circuit board. Feeding parts of the radiation conductor plate are connected to the wiring pattern, a plurality of mounting legs formed by bending the radiation conductor plate toward the circuit board is provided to portions of the radiation conductor plate other than the center thereof, and the plurality of the mounting legs is soldered to the solder lands.

Since the antenna device according to the invention can be operated as a sheet metal patch antenna by disposing the radiation conductor plate made of a metal sheet on the circuit board so as to face the one surface of the circuit board with an air space having a predetermined thickness formed therebetween, it is possible to reduce the cost of components compared to a dielectric antenna. In a case of the sheet metal patch antenna, since the solder lands to which the mounting legs of the radiation conductor plate are soldered face the ground pattern with the circuit board interposed therebetween, additional capacitance is formed between the solder lands and the ground pattern. Therefore, a resonant frequency is lowered whereby a sheet metal patch antenna, which can be easily miniaturized, is obtained. Moreover, since the resonant frequency varies depending on the size and arrangement of the plurality of the solder lands, it is also easy to perform fine adjustment of the resonant frequency and to make the bandwidth of the resonant frequency wider.

In the above-mentioned structure, it is preferable that each of the mounting legs be provided with a first locking means locked in the circuit board and outer circumference of the shield case be provided with a second locking means locked in the circuit board. That is, in the assembling process of the antenna device, if the radiation conductor plate is self-supported on the circuit board by first locking means of the mounting legs and the shield case is reflow-soldered on the circuit board in a state in which the shield case is self-supported by second locking means, a soldering work for soldering the mounting legs to the solder lands and a soldering work for soldering the shield case to the ground pattern are performed in a lump. Therefore, it is possible to reduce assembly cost by reducing the number of the processes.

In this case, through holes facing the solder lands are provided on the circuit board and each of the tips of the mounting legs is provided with an elastic hook as the first locking means. If each of the mounting legs is engaged with the circuit board by press-fitting each of the elastic hooks into each of the through holes, the radiation conductor plate can be temporarily fixed on the circuit board with ease and accuracy before the reflow-soldering. Furthermore, if a plurality of notches is formed on the outer circumference of the circuit board and a plurality of elastic locking pieces projecting toward the circuit board is provided on the outer circumference of the shield case as the second locking means, and each of the elastic locking pieces is snap-fitted into each of the notches, the shield case can be temporarily fixed on the circuit board with ease and accuracy before the reflow-soldering, which is preferable.

In addition, the above-mentioned antenna device preferably may further include a radome which is disposed so as to cover the radiation conductor plate and the circuit board, and a reflecting plate which is disposed so as to face the circuit board with the shield case interposed therebetween. It is preferable that the reflecting plate be made of a metal sheet larger than the radiation conductor plate, and a case be formed by fitting the radome on the reflecting plate. Accordingly, the antenna device having dust resistance and a waterproof property is obtained by receiving the reflecting plate, the circuit board and shield case in the case, and it is possible to improve gain by reflecting the electric wave with the reflecting plate to control radiation of the electric wave in the undesirable direction. In this case, if the antenna device includes a magnet, which is mounted on the surface of the reflecting plate opposite to the shield case, it is possible to easily mount the antenna device on any portion of a vehicle, such as a portion in which a metal is buried or on a portion to which a metal is exposed.

Moreover, in the above-mentioned structure, it is preferable that the shield case include a flat plate facing the other surface of the circuit board and a plurality of sidewalls bent from the circumference of the flat plate. In this case, it is preferable that one of the sidewalls be provided with a substantially U-shaped cable holding part, the cable holding part be projected from the flat plate by cutting and bending a portion of the cable holding part from one of relief holes formed on the flat plate, and an outer conductor of a coaxial cable be soldered to the cable holding part. Accordingly, since an area (solder region) required for soldering is ensured in the cable holding part, it is possible to control the height of the shield case.

### BRIEF DESCRIPTION OF THE DRAWINGS

Fig. 1 is a cross-sectional view showing the overall structure of an antenna device according to an embodiment of the invention;
Fig. 2 is a perspective view showing the antenna device as seen from the bottom side thereof;
Fig. 3 is a perspective view showing a state in which a reflecting plate is removed from Fig. 2;
Fig. 4 is a perspective view showing a seal member assembled in the antenna device;
Fig. 5 is a perspective view showing a main body of the antenna device;
Fig. 6 is an exploded perspective view showing the main body;
Fig. 7 is a perspective view showing a shield case included in the main body as seen from the rear side thereof;
Fig. 8 is a perspective view showing a soldered portion between the shield case and a coaxial cable;
Fig. 9 is a cross-sectional view of the main body taken along the line A-A shown in Fig. 5;
Fig. 10 is an enlarged view of a B portion shown in Fig. 5; and
Fig. 11 is a cross-sectional view showing a conventional antenna device.

### DESCRIPTION OF THE PREFERRED EMBODIMENT

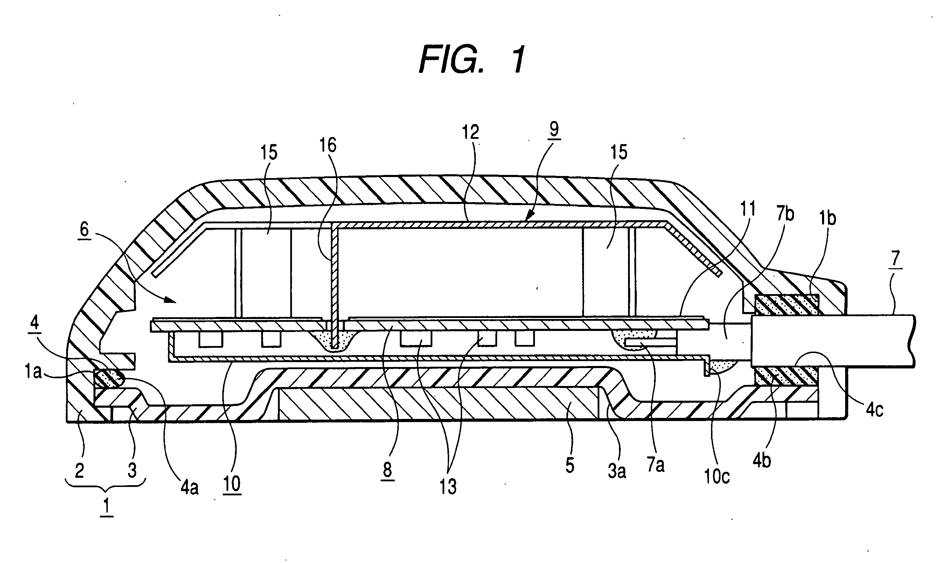

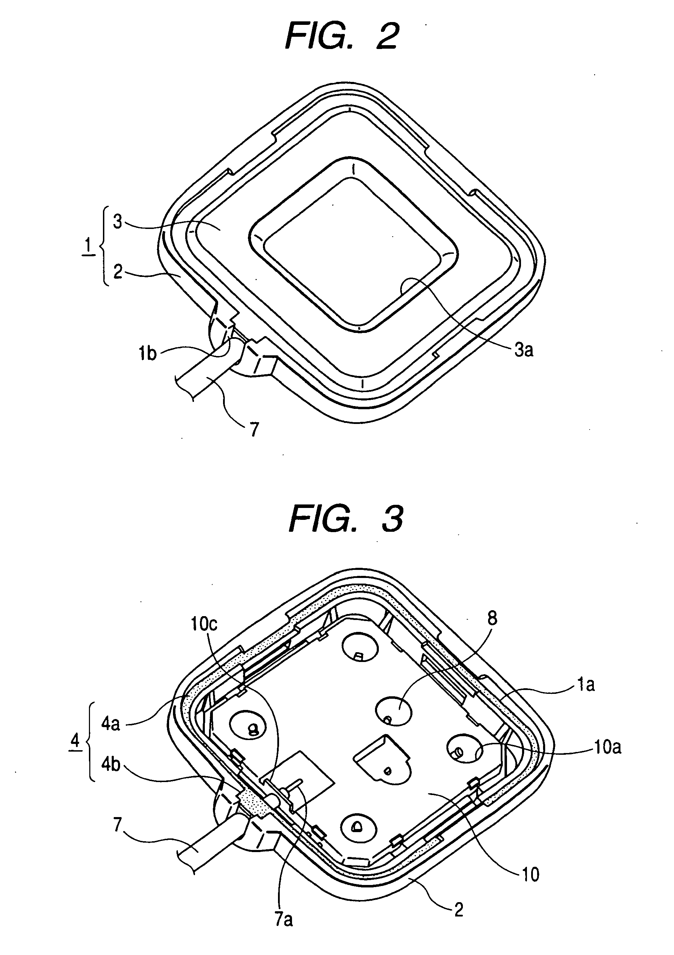

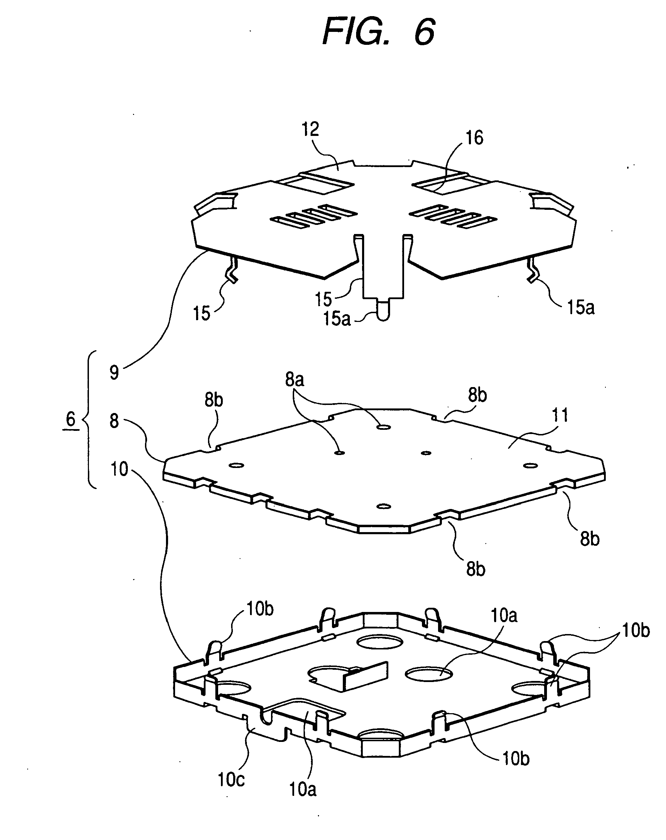

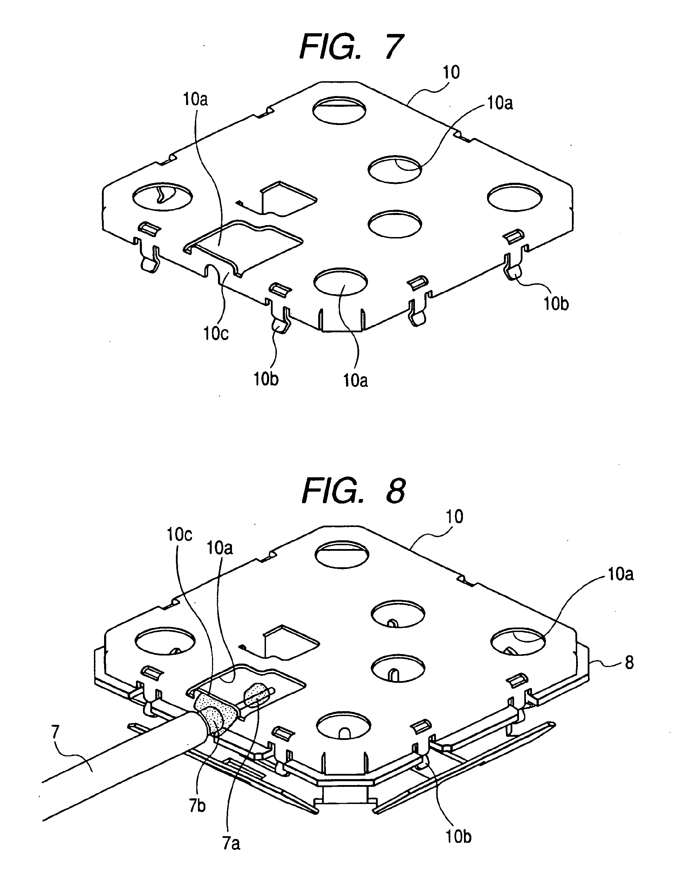

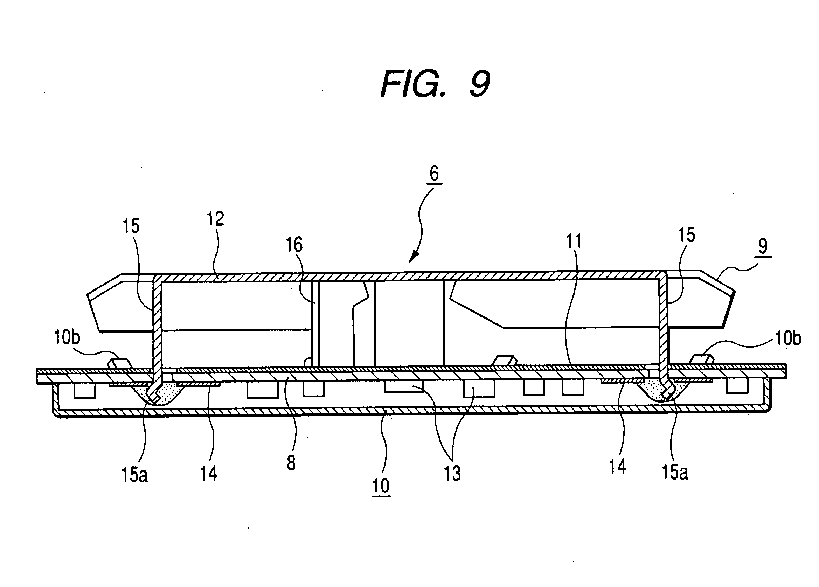

An embodiment of the invention will be described with reference to the accompanying drawings. Fig. 1 is a cross-sectional view showing the overall structure of an antenna device (antenna unit) according to an embodiment of the invention, Fig. 2 is a perspective view showing the antenna device as seen from the bottom side thereof, Fig. 3 is a perspective view showing a state in which a reflecting plate is removed from Fig. 2, Fig. 4 is a perspective view showing a seal member assembled in the antenna device, Fig. 5 is a perspective view showing a main body of the antenna device, Fig. 6 is an exploded perspective view showing the main body, Fig. 7 is a perspective view showing a shield case included in the main body as seen from the rear side thereof, Fig. 8 is a perspective view showing a soldered portion between the shield case and a coaxial cable, Fig. 9 is a cross-sectional view of the main body taken along the line A-A shown in Fig. 5, and Fig. 10 is an enlarged view of a B portion shown in Fig. 5.

The antenna device shown in these drawings mainly includes a case 1 which is constructed by fitting a radome 2 serving as an upper case on a reflecting plate 3 serving as a lower case, a seal member 4 mounted to the fitting portion 1a between the radome 2 and the reflecting plate 3, a magnet 5 attached on the lower surface of the reflecting plate 3, a main body 6 received in the inner space of the case 1, and a coaxial cable 7 for electrically connecting the main body 6 with an external circuit (receiving circuit, etc.) which is not shown. Here, the main body 6 is composed of a circuit board 8 having an electronic circuit unit, such as a low noise amplifying circuit, an antenna element 9 serving as a sheet metal patch antenna, and a shield case 10 made of a metal sheet (see Fig. 6). In this case, a ground pattern 11 provided on the substantially entire upper surface of the circuit board 8 and a radiation conductor plate 12 of the antenna element 9 face each other at a predetermined interval. Furthermore, a wiring pattern (not shown) is provided on the lower surface of the circuit board 8, and various electronic components 13 connected to the wiring pattern are mounted on the lower surface of the circuit board 8. In this case, these electronic components 13 and the wiring pattern form the electronic circuit unit on the lower surface of the circuit board 8.

The radome 2 serving as an upper case is a molded article made of a synthetic resin, and has a lower opening thereof so as to cover the main body 6. The reflecting plate 3 serving as a lower case is formed by pressing a metal sheet, and the reflecting plate 3 covers the lower opening of the radome 2. The reflecting plate 3 has a recess 3a that is formed on the center of the lower surface thereof, and the magnet 5 is fixed in the recess 3a (however, the magnet 5 is omitted in Fig. 2). The reflecting plate 3 is set so as to be larger than the radiation conductor plate 12 of the antenna element 9. The case 1 is assembled by fitting the radome 2 on the reflecting plate 3, and the fitting portion 1a formed in a substantially square frame shape and a cable outlet port 1b adjacent to the fitting portion 1a are formed in the radome 2 and the reflecting plate 3. As shown in Fig. 3, a gap formed between the fitting portion 1a and the cable outlet port 1b is sealed by mounting an annular mounted part 4a of the seal member 4 in the fitting portion 1a and by mounting a cable insertion part 4b of the seal member 4 in the cable outlet port 1b.

The seal member 4 is a molded article made of an elastic material, such as elastomer, and the annular mounted part 4a and the cable insertion part 4b of the seal member 4 are integrally formed in a shape shown in Fig. 4 before the assembly of the seal member 4 into the case 1 (unloaded condition). That is, the annular mounted part 4a is formed in a substantially rectangular frame shape, which is similar to the shape of the fitting portion 1a. In addition, the cable insertion part 4b is formed so that a convex body of appearance to be fitted into the cable outlet port 1b has an insertion hole 4c, and the axial direction of the insertion hole 4c coincides with the annular mounted part 4a. Since the annular mounted part 4a is coupled with one corner of the cable insertion part 4b, as shown by an arrow C of Fig. 4, the cable insertion part 4b can be rotated along a plane substantially orthogonal to the extending direction of a portion of the annular mounted part 4a which is adjacent to the cable insertion part 4b. Further, the insertion hole 4c of the cable insertion part 4b is used for inserting the coaxial cable 7 therethrough. When the seal member 4 is assembled in the case 1, after inserting the coaxial cable 7 into the insertion hole 4c, the cable insertion part 4b is mounted in the cable outlet port 1b in a state in which the cable insertion part 4b is elastically rotated by 90° in the direction of the arrow C, and the annular mounted part 4a is mounted in the fitting portion 1a. In this way, as shown in Fig. 3, since the axial direction of the insertion hole 4c can be set to be substantially perpendicular to that of the annular mounted part 4a (heightwise direction of the case 1), it is easy to lead the coaxial cable 7.

Hereinafter, the main body 6 of the antenna device will be described. A central conductor 7a of the coaxial cable 7 is soldered to the wiring pattern, which is formed on the lower surface of the circuit board 8, and solder lands 14 (see Fig. 9), which is electrically independent from the wiring pattern, are provided at four positions on the lower surface of the circuit board 8. In addition, as shown in Fig. 6, through holes 8a are provided at a plurality of positions including positions corresponding to the corresponding the solder lands 14, on the circuit board 8, and a plurality of recessed notches 8b is formed on the outer circumference of the circuit board 8.

The antenna element 9 includes the radiation conductor plate 12 facing the ground pattern 11 with an air space having a predetermined thickness formed therebetween, mounting legs 15 formed by bending four portions of the radiation conductor plate 12 other than the center thereof toward the circuit board 8, and power feeding segments 16 formed by bending two portions close to the center of the radiation conductor plate 12 toward the circuit board 8. The four mounting legs 15 and the two power feeding segments 16 are inserted into the corresponding through holes 8a, respectively, and then soldered on the lower surface of the circuit board 8. In this case, the mounting legs 15 are respectively connected to the solder lands 14 and the power feeding segments 16 is connected to the wiring pattern. In addition, as shown in Fig. 9, an elastic hook 15a is formed at each of the tips of the mounting legs 15, and each of the mounting legs 15 is caught in the circuit board 8 by press-fitting each of the elastic hooks 15a into each of the through holes 8a. Consequently, the antenna element 9 can be temporarily fixed on the circuit board 8 with ease and accuracy by press-fitting the elastic hooks 15a into the corresponding through holes 8a, respectively. In this way, the antenna element 9 is fixed to the circuit board 8 by soldering the self-supported antenna element 9 using a reflow oven.

The shield case 10 covers the electronic components 13 of the low noise amplifying circuit, whereby possibility that characteristics of an antenna deteriorates and an interfering wave from the outside adversely affects the low noise amplifying circuit by an undesirable electronic wave radiated from the low noise amplifying circuit is considerably reduced. Therefore, it is easy to ensure high reliability. The shield case 10 has a flat plate facing the lower surface of the circuit board 8 and a plurality of sidewalls bent from the circumference of the flat plate, and the flat plate is provided with a plurality of relief holes 10a that faces the soldering portions of the lower surface of the circuit board 8. Furthermore, a plurality of elastic locking pieces 10b projects upward on the sidewalls of the shield case 10. These elastic locking pieces 10b are snap-fitted into the corresponding notches 8b that are provided in the circumference of the circuit board 8, and then soldered to the ground pattern 11 formed on the upper surface of the circuit board 8. Even in this case, since the shield case 10 can be temporarily fixed on the circuit board 8 with ease and accuracy by snap-fitting each of the elastic locking pieces 10b into the corresponding notches 8b, the shield case 10 is fixed to the circuit board 8 by soldering the self-supported shield case 10 using a reflow oven. In addition, a substantially U-shaped cable holding part 10c for holding the coaxial cable 7 is formed in one sidewall of the shield case 10, and the lower end of the cable holding part 10c projects downward from the flat plate by cutting and bending the lower end (upper end in Fig. 7) of the cable holding part 10c downward from one of the relief holes 10a. Consequently, as shown in Fig. 8, when an outer conductor 7b of the coaxial cable 7 is soldered to the cable holding part 10c, since an area (solder region) required for soldering is ensured in the cable holding part 10c, it is possible to control the height of the shield case 10. Furthermore, since the lower end of the cable holding part 10c is cut and bent downward from the relief hole 10a, the size of the relief hole 10a is increased by cutting and bending the lower end of the cable holding part 10c in order to solder the central conductor 7a of the coaxial cable 7 passing through the relief hole 10a to the wiring pattern of the circuit board 8. As a result, it is possible to simply perform a soldering work of the central conductor 7a.

The antenna device having above-mentioned structure can be operated as a circularly polarized wave antenna by performing two-point feed to the radiation conductor plate 12 through the two power feeding segments 16 connected to the wiring pattern of the circuit board 8. That is, if a predetermined high frequency signal is supplied to the radiation conductor plate 12 through the low noise amplifying circuit, an electric wave, such as a circularly polarized wave, is radiated from the radiation conductor plate 12. Then, if the signal wave is received by the radiation conductor plate 12, the electrical signal is output to the external receiving circuit via the low noise amplifying circuit and the coaxial cable 7.

Moreover, in the antenna device according to the present embodiment, since the main body 6 including the circuit board 8 and the radiation conductor plate 12 is received in the case 1 and the seal member 4 is mounted in the fitting portion 1a of the case 1 and in the cable outlet port 1b, it is possible to ensure dust resistance and a waterproof property. Furthermore, since the annular mounted part 4a mounted in the fitting portion 1a and the cable insertion part 4b mounted in the cable outlet port 1b are integrally formed in the seal member 4, it is possible to easily perform assembling work of the seal member 4 compared to when the seal member 4 is assembled with two separate seal members. Moreover, since there is no gap between the annular mounted part 4a and the cable insertion part 4b, a sealing effect on the cable outlet port 1b is also improved. Accordingly, by employing the above-mentioned seal structure, it is possible to reduce assembly cost of the antenna device and to improve dust resistance and a waterproof property. In addition, since the axial direction of the insertion hole 4c of the seal member 4 coincides with that of the annular mounted part 4a thereof in the unloaded condition, a mold opening direction is the same as the axial direction, whereby slide cores, etc. are not required in a mold at the time of molding of the seal member 4. Therefore, it is possible to manufacture the seal member 4 using a mold with a simple structure at a low price. Further, when the seal member 4 is assembled in the case 1, the cable insertion part 4b is mounted in the cable outlet port 1b in a state in which the cable insertion part 4b is elastically rotated. As a result, the axial direction of the insertion hole 4c can be set to be substantially perpendicular to that of the annular mounted part 4a (heightwise direction of the case 1), whereby the coaxial cable 7 can be easily led.

Furthermore, in the antenna device according to the present embodiment, since the solder lands 14 to which the mounting legs 15 of the radiation conductor plate 12 are soldered face the ground pattern 11 with the circuit board 8 interposed therebetween, additional capacitance is formed between the solder lands 14 and the ground pattern 11. Therefore, a resonant frequency is lowered whereby it is easy to miniaturize the antenna element 9. Moreover, since the resonant frequency varies depending on the size and arrangement of the plurality of the solder lands 14, it is also easy to perform fine adjustment of the resonant frequency and to make the bandwidth of the resonant frequency wider. In addition, since the antenna device uses the reflecting plate 3 as a lower case made of metal, it is possible to improve gain by reflecting the electric wave with the reflecting plate 3 to control radiation of the electric wave in the undesirable direction. Furthermore, since the magnet 5 is fixed in the recess 3a formed on the lower surface of the reflecting plate 3, it is possible to easily mount the antenna device on any portion of a vehicle, such as a portion in which a metal is buried or a portion to which a metal is exposed.

Further, in the antenna device according to the present embodiment, since the antenna element 9 can be self-supported on the circuit board 8 before the soldering process by press-fitting each of the elastic hooks 15a of the mounting legs 15 into each of the through holes 8a and the shield case 10 can be self-supported on the circuit board 8 before the soldering process by snap-fitting each of the elastic locking pieces 10b into each of the notches 8b, it is possible to reflow-solder the antenna element 9 and the shield case 10 in a lump. That is, in the assembling process of the antenna device, after applying cream solder to predetermined positions of the circuit board 8 to which the mounting legs 15, the power feeding segments 16, the elastic locking pieces 10b, etc. are soldered, the antenna element 9 and the shield case 10 are mounted on the circuit board 8. In this case, since the antenna element 9 is temporarily fixed on the circuit board 8 by press-fitting of the elastic hooks 15a and the shield case 10 is temporarily fixed on the circuit board 8 by snap-fitting of the elastic locking pieces 10b, it is possible to reflow-solder the antenna element 9 and the shield case 10 in a lump in a state in which the antenna element 9 and the shield case 10 are self-supported on the circuit board 8. According to the above-mentioned structure, since the number of processes is reduced compared to when the antenna element 9 and the shield case 10 are separately reflow-soldered, it is possible to reduce assembly cost to a large extent. Furthermore, in the antenna device, since the antenna element 9 is a sheet metal patch antenna, it goes without saying that the cost of components can be reduced compared to a dielectric antenna.

The shape or feeding system or the like of the antenna element 9 can be properly selected, for example, the invention is also applied to an antenna device having one-point feeding system for a linearly polarized wave.

Since the antenna device according to the invention can be operated as a sheet metal patch antenna, it is possible to reduce the cost of components compared to a dielectric antenna. In addition, since additional capacitance is formed between the solder lands to which the mounting legs of the radiation conductor plate are soldered and the ground pattern formed on one surface of the circuit board, a resonant frequency is lowered whereby it is easy to miniaturize the overall antenna device.

Moreover, in the antenna device, if the radiation conductor plate is self-supported on the circuit board by first locking means of the mounting legs and the shield case is reflow-soldered on the circuit board in a state in which the shield case is self-supported by second locking means, a soldering work for soldering the mounting legs to the solder lands and a soldering work for soldering the shield case to the ground pattern are performed in a lump. Therefore, it is possible to reduce assembly cost by reducing the number of the processes.

## Claims

1. An antenna device comprising:
a circuit board (8) which is provided with a ground pattern (11) on substantially one entire surface thereof and is provided with a wiring pattern and a plurality of solder lands (14) facing the ground pattern (11) on the other surface thereof;
electronic components (13) which are mounted on the other surface of the circuit board (8) and are connected to the wiring pattern;
a shield case (10) which is made of a metal sheet and is soldered to the ground pattern (11) so as to cover the electronic components (13); and
a radiation conductor plate (12) which is made of a metal sheet and is disposed on the circuit board (8) so as to face the one surface of the circuit board (8),
**characterized in that** feeding parts of the radiation conductor plate (12) are connected to the wiring pattern, a plurality of mounting legs (15) formed by bending the radiation conductor plate (12) toward the circuit board (8) is provided to portions of the radiation conductor plate (12) other than the center thereof, and the plurality of the mounting legs (15) is soldered to the solder lands (14).

2. The antenna device according to claim 1,
**characterized in that** each of the mounting legs (15) is provided with a first locking means locked in the circuit board (8) and outer circumference of the shield case (10) is provided with a second locking means locked in the circuit board (8).

3. The antenna device according to claim 2,
**characterized in that** through holes (8a) facing the solder lands (14) are provided on the circuit board (8), each of the tips of the mounting legs (15) is provided with an elastic hook (15a) as the first locking means, and each of the mounting legs (15) is engaged with the circuit board (8) by press-fitting each of the elastic hooks (15a) into each of the through holes (8a).

4. The antenna device according to claim 2 or 3,
**characterized in that** a plurality of notches (8b) is formed on the outer circumference of the circuit board (8), a plurality of elastic locking pieces (10b) projecting toward the circuit board (8) is provided on the outer circumference of the shield case (10) as the second locking means, and each of the elastic locking pieces (10b) is snap-fitted into each of the notches (8b).

5. The antenna device according to any one of claims 1 to 4, further comprising:
a radome (2) which is disposed so as to cover the radiation conductor plate (12) and the circuit board (8); and
a reflecting plate (3) which is disposed so as to face the circuit board (8) with the shield case (10) interposed therebetween;
**characterized in that** the reflecting plate (3) is made of a metal sheet larger than the radiation conductor plate (12), and a case (1) is formed by fitting the radome (2) on the reflecting plate (3).

6. The antenna device according to claim 5, further comprising:
a magnet (2) which is mounted on the surface of the reflecting plate (3) opposite to the shield case (10).

7. The antenna device according to any of claims 1 to 6,
**characterized in that** the shield case (10) includes a flat plate facing the other surface of the circuit board (8) and a plurality of sidewalls bent from the circumference of the flat plate, one of the sidewalls is provided with a substantially U-shaped cable holding part (10c), the cable holding part (10c) projects from the flat plate by cutting and bending a portion of the cable holding part (10c) from one of relief holes (10a) formed on the flat plate, and an outer conductor (7b) of a coaxial cable (7) is soldered to the cable holding part (10c).

## Patentansprüche

1. Antennenvorrichtung, aufweisend:
eine Leiterplatte (8), die im Wesentlichen auf ihrer gesamten einen Oberfläche mit einem Erdungsmuster (11) versehen ist und die auf ihrer anderen Oberfläche mit einem Verdrahtungsmuster und einer Mehrzahl von Lötanschlussflächen (14) gegenüber von dem Erdungsmuster (11) versehen ist;
elektronische Komponenten (13), die an der anderen Oberfläche der Leiterplatte (8) angebracht sind und mit dem Verdrahtungsmuster verbunden sind;
ein Abschirmgehäuse (10), das aus Metallblech gebildet ist und mit dem Erdungsmuster (11) verlötet ist, so dass die elektronischen Komponenten (13) überdeckt sind; und
eine Strahlungsleiterplatte (12), die aus Metallblech gebildet ist und auf der Leiterplatte (8) derart angeordnet ist, dass sie der einen Oberfläche der Leiterplatte (8) zugewandt gegenüberliegt,
**dadurch gekennzeichnet, dass** Einspeisebereiche der Strahlungsleiterplatte (12) mit dem Verdrahtungsmuster verbunden sind, dass eine Mehrzahl von Befestigungsschenkeln (15), die durch Umbiegen der Strahlungsleiterplatte (12) in Richtung auf die Leiterplatte (8) gebildet sind, in anderen Bereichen der Strahlungsleiterplatte (12) als dem Zentrum von dieser vorgesehen sind und dass die Mehrzahl der Befestigungsschenkel (15) mit den Lötanschlussflächen (14) verlötet ist.

2. Antennenvorrichtung nach Anspruch 1,
**dadurch gekennzeichnet, dass** jeder der Befestigungsschenkel (15) mit einer ersten Verriegelungseinrichtung zur Verriegelung in der Leiterplatte (8) versehen ist und ein Außenumfang des Abschirmgehäuses (10) mit einer zweiten Verriegelungseinrichtung zur Verriegelung mit der Leiterplatte (8) versehen ist.

3. Antennenvorrichtung nach Anspruch 2,
**dadurch gekennzeichnet, dass** den Lötanschlussflächen (14) zugewandte Durchgangsöffnungen (8a) in der Leiterplatte (8) vorgesehen sind, dass die Endbereiche der Befestigungsschenkel (15) jeweils mit einem elastischen Haken (15a) als erste Verriegelungseinrichtung versehen sind, und dass die Befestigungsschenkel (15) jeweils durch Presseinpassen jedes elastischen Hakens (15a) in eine jeweilige Durchgangsöffnung (8a) mit der Leiterplatte (8) in Eingriff gebracht sind.

4. Antennenvorrichtung nach Anspruch 2 oder 3,
**dadurch gekennzeichnet, dass** eine Mehrzahl von Kerben (8b) an dem Außenumfang der Leiterplatte (8) gebildet ist, dass eine Mehrzahl elastischer Verriegelurigsstücke (10b), die in Richtung auf die Leiterplatte (8) vorstehen, an dem Außenumfang des Abschirmgehäuses (10) als zweite Verriegelungseinrichtung vorgesehen ist, und dass die elastischen Verriegelungsstücke (10b) jeweils im Schnappeingriff in einer jeweiligen Kerbe (8b) angeordnet sind.

5. Antennenvorrichtung nach einem der Ansprüche 1 bis 4, weiterhin aufweisend:
ein Radom (2), das die Strahlungsleiterplatte (12) und die Leiterplatte (8) überdeckend angeordnet ist; und
eine reflektierende Platte (3), die unter Zwischenanordnung des Abschirmgehäuses (10) der Leiterplatte (8) gegenüberliegend angeordnet ist;
**dadurch gekennzeichnet, dass** die reflektierende Platte (3) aus einem Metallblech gebildet ist, das größer ist als die Strahlungsleiterplatte (12), und dass ein Gehäuse (1) durch Passen des Radoms (2) auf die reflektierende Platte (3) gebildet ist.

6. Antennenvorrichtung nach Anspruch 5, weiterhin aufweisend:
einen Magneten (2), der an der dem Abschirmgehäuse (10) entgegengesetzten Oberfläche der reflektierenden Platte (3) angebracht ist.

7. Antennenvorrichtung nach einem der Ansprüche 1 bis 6,
**dadurch gekennzeichnet, dass** das Abschirmgehäuse (10) eine ebene Platte, die der anderen Oberfläche der Leiterplatte (8) gegenüberliegt, sowie eine Mehrzahl von Seitenwänden aufweist, die von dem Umfang der ebenen Platte umgebogen sind, dass eine der Seitenwände mit einem im Wesentlichen U-förmigen Kabelhalteteil (10c) versehen ist, dass das Kabelhalteteil (10c) von der ebenen Platte weg ragt, indem ein Bereich des Kabelhalteteils (10c) geschnitten und von einer von mehreren Freiraumöffnungen (10a) umgebogen ist, die in der ebenen Platte gebildet sind, und dass ein äußerer Leiter (7b) eines Koaxialkabels (7) mit dem Kabelhalteteil (10c) verlötet ist.

## Revendications

1. Dispositif d'antenne comprenant :
une carte de circuit imprimé (8) qui comporte un motif de mise à la masse (11) sur sensiblement une surface complète de celle-ci, et qui comporte un motif de câblage et une pluralité de plages de connexion (14) qui font face au motif de mise à la masse (11) sur une autre surface de celle-ci
des composants électroniques (13) qui sont montés sur l'autre surface de la carte de circuit imprimé (8) et qui sont connectés au motif de câblage ;
un boîtier de protection (10) qui est fait d'une feuille de métal et qui est soudé au motif de mise à la masse (11) de façon à recouvrir les composants électroniques (13) ; et
une plaque conductrice de rayonnement (12) qui est faite d'une feuille de métal et qui est placée sur la carte de circuit imprimé (8) de façon à faire face à une surface de la carte de circuit imprimé (8),
**caractérisé en ce que** des parties d'alimentation de la plaque conductrice de rayonnement (12) sont connectées au motif de câblage, une pluralité de pattes de montage (15) formée en pliant la plaque conductrice de rayonnement (12) vers la carte de circuit imprimé (8) est prévue sur des portions de la plaque conductrice de rayonnement (12) autres que le centre de celle-ci, et la pluralité de pattes de montage (15) est soudée aux plages de connexion (14).

2. Dispositif d'antenne selon la revendication 1,
**caractérisé en ce que** chacune des pattes de montage (15) est pourvue de premiers moyens de blocage qui sont bloqués dans la carte de circuit imprimé (8), et qu'une circonférence extérieure du boîtier de protection (10) est pourvue de seconds moyens de blocage qui sont bloqués dans la carte de circuit imprimé (8).

3. Dispositif d'antenne selon la revendication 2,
**caractérisé en ce que** des trous traversants (8a) qui font face aux plages de connexion (14) sont prévus sur la carte de circuit imprimé (8), chacune des pointes des pattes de montage (15) est pourvue d'un crochet élastique (15a) en tant que les premiers moyens de blocage, et chacune des pattes de montage (15) est engagée avec la carte de circuit imprimé (8) par montage à la presse de chacun des crochets élastiques (15a) à l'intérieur de chacun des trous traversants (8a).

4. Dispositif d'antenne selon la revendication 2 ou 3,
**caractérisé en ce qu'**une pluralité d'encoches (8b) est formée sur la circonférence extérieure de la carte de circuit imprimé (8), une pluralité de pièces de blocage élastiques (10b) faisant saillie vers la carte de circuit imprimé (8) est prévue sur la circonférence extérieure du boîtier de protection (10) en tant que les seconds moyens de blocage, et chacune des pièces de blocage élastiques (10b) est montée par emboîtement à l'intérieur de chacune des encoches (8b).

5. Dispositif d'antenne selon l'une quelconque des revendications 1 à 4, comprenant en outre :
un capot d'antenne (2) qui est disposé de manière à recouvrir la plaque conductrice de rayonnement (12) et la carte de circuit imprimé (8) ; et
une plaque réfléchissante (3) qui est disposée de manière à faire face à la carte de circuit imprimé (8) avec le boîtier de protection (10) disposé de façon intermédiaire entre elles ;
**caractérisé en ce que** la plaque réfléchissante (3) est faite d'une feuille de métal qui est plus large que la plaque conductrice de rayonnement (12), et un boîtier (1) est formé par montage du capot d'antenne (2) sur la plaque réfléchissante (3).

6. Dispositif d'antenne selon la revendication 5, comprenant en outre :
un aimant (2) qui est monté sur la surface de la plaque réfléchissante (3) à l'opposé du boîtier de protection (10).

7. Dispositif d'antenne selon l'une quelconque des revendications 1 à 6,
**caractérisé en ce que** le boîtier de protection (10) comprend une plaque plate qui fait face à l'autre surface de la carte de circuit imprimé (8) et une pluralité de parois latérales recourbées à partir de la circonférence de la plaque plate, une des parois latérales comporte une partie de maintien de câble sensiblement en forme de U (10c), la partie de maintien de câble (10c) fait saillie par rapport à la plaque plate par découpe et pliage d'une portion de la partie de maintien de câble (10c) à partir d'un parmi des trous de secours (10a) formés sur la plaque plate, et un conducteur externe (7b) d'un câble coaxial (7) est soudé à la partie de maintien de câble (10c).
